# EUROPEAN PATENT APPLICATION

(11) **EP 1 596 625 A1**
(43) Date of publication of application: **16.11.2005**
(21) Application number: 04450105.4
(22) Date of filing: 11.05.2004
(51) Int. Cl.: H04R 3/08, H04R 1/00, H03M 1/82

(54) **Circuit for the control of a loudspeaker**

(71) Applicant: AKG Acoustics GmbH, 1230 Wien (AT)
(72) Inventor: Seknicka, Otto, 2560 Berndorf (AT)
(74) Representative: Patentanwälte BARGER, PISO & PARTNER

(57) **Abstract**

The invention concerns a circuit for the control of a loudspeaker with a loudspeaker capsule (18), wherein the circuit consists of a bit-splitter (6) for the division of a data item, representing an acoustic signal, into a high-order bit group and a low-order bit group, as well as two D/A converters (1, 2) for the D/A conversion of the high-order bit group and the low-order bit group, wherein the digital inputs of the D/A converters (1, 2) are connected with an output of the bit-splitter (6).

The invention is characterized in that a complement stage (5) for the negation of its bit group is connected in series with the D/A converter (2, 1), and that the output of one D/A converter (1, 2) is connected with a terminal of the loudspeaker capsule (18), with the output of the other D/A converter (2, 1) being connected with the other terminal of the loudspeaker capsule (18).

## Description

The invention relates to a circuit for the control of a loudspeaker according to the preamble of Claim 1.

A method is known for the circumvention of difficulties appearing during the conversion of digital signals by means of D/A converters or pulse width modulators (PWM) - among these are the excessively low resolution in the conversion of a high-frequency signal and the interfering signals -, wherein the data items to be converted are split into high-order and low-order bit groups and are converted into analog signals, separately from one another. Subsequently, the individual analog signals are brought together, once more, according to a weighting process. The great advantage of this method is to be found in that by dividing the data items, the required cycle frequency of the individual PWM modulators and thus also the circuit expenditure can be reduced. For example, a cycle of (2¹⁶)×44100 Hz = 2.89 GHz would be produced with a 16-bit resolution and a sample rate of 44.1 kHz, which today is not feasible at a low cost.

Thus, for example, WO 99/40683 describes a method for D/A conversion, in which a 16-bit data item is split into three parts, wherein the six highest bits are converted into a 6-bit bit group, the nine lowest bits are converted into a 9-bit bit group, and the seven middle bits are converted into a 7-bit bit group, wherein the 7-bit bit group overlaps, with its ends, with the two other bit groups. The individual bit groups are converted, by means of PWMs, into analog signals. The individual analog signals are summed with a specific weighting, which takes place via resistances.

Methods based on a similar principle, in which the data item, however, is split only into two bit groups, are also known from the JP 64 058125 A, JP 2003 298 423 A, and JP 2001 069008 A.

The state of the art closest to the invention under consideration is described in JP 59 034795 A and JP 59 034796 A. A data item, in this case, an audio signal, is split into a high-order 6-bit bit group and a low-order 6-bit bit group. Subsequently, the separated D/A conversion takes place in two PWM converters. The PWM signals thereby formed arrive at so-called "switching sections," which function as amplifiers, and are weighted there with respect to one another, in the ratio of 64:1. The amplified or weighted signals are laid on two reels of a loudspeaker, separately from one another, and thus produce the desired audio signal. The analog signals coming from the two bit groups overlap because of the reels independent of one another, first in the form of electromagnetic fields or even as diaphragm oscillations. Especially at high frequencies, there may be distortions, which can greatly impair the quality of the acoustical loudspeaker signal. The spatial distance between the reel and barely avoidable irregularities in the form of windings of the reels can also lead to unintended additional weightings of the two independent analog signals and thus result in a changed audio signal.

One serious disadvantage is to be found in that with these methods, only dynamic loudspeakers can be controlled with two reels. This method is therefore limited to specially shaped, and therefore expensive, dynamic loudspeaker capsules.

There is a need for a solution of the problems resulting from the state of the art, by means of which both the quality of the audio signal formed and also a low-cost implementation are fulfilled as essential criteria.

In accordance with the invention, these goals are attained in that a complement stage for the negation of its bit group is connected in series with one of the D/A converters, and that the exit of one D/A converter is connected with a terminal of the loudspeaker capsule and the exit of the other D/A converter is connected with the other terminal of the loudspeaker capsule.

The advantages of a loudspeaker control, in accordance with the invention, are based on the fact that a differential voltage corresponding to the converted data items is directly formed between the loudspeaker terminals. Therefore, there is no need for a subsequent overlapping of the two bit groups converted into analog signals, separately from one another, as is the case in the state of the art. Thus, the difficulties arising in a subsequent overlapping can be avoided from the very beginning.

Another advantage of the invention under consideration is to be found in that together with the loudspeaker control, in accordance with the invention, the usual small loudspeaker capsules, which have only one loudspeaker reel, as well as piezoelectric sound converters and capacitor loudspeakers, can also be used. Special embodiments of sound converters, especially adapted to the loudspeaker control, are not needed, which has a favorable effect on cost and gives the possibility for universal applicability.

Another advantage of the invention is to be found in the fact that with a development of the D/A converter as a digital amplifier, the power consumption can be kept low, in comparison to analog amplifiers. The number of components required for the loudspeaker control can be greatly reduced, moreover - for example, by the use of favorable flash-DSPs, without a I²S interface.

By the use of DSP's or microcontrollers, which have PWM modular outputs, it becomes possible to undertake a direct control of the loudspeaker in HiFi quality. Furthermore, the method offers a savings potential for devices with a very high degree of integration due to its easy implementability in FPGA's and ASIC's.

The invention is explained in more detail below with the aid of drawings. The figures show the following:
Fig. 1, an embodiment example of a loudspeaker control, in accordance with the invention;
Fig. 2, a switched final stage in the form of a MOSFET single-ended, push-pull output stage with inverter; and
Fig. 3, an embodiment example of a bit-splitter, in which a parallel data flow is split into a low-byte flow and a high-byte flow.

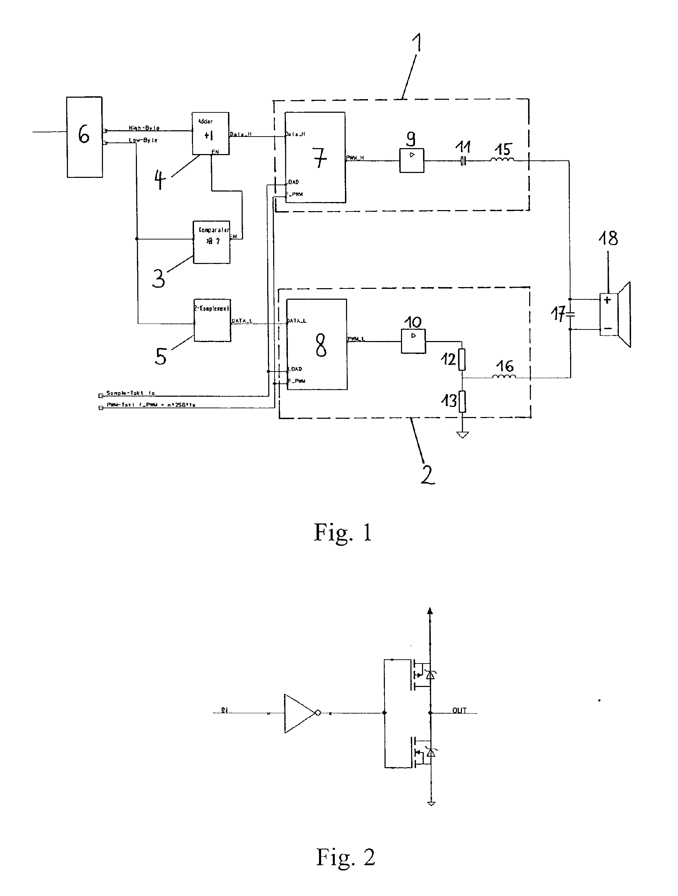

Fig. 1 shows an embodiment example of a circuit for the control of a loudspeaker, in accordance with the invention, for example, a small loudspeaker in a digital headphone, in which the 16-bit digital/analog conversion takes place at a conversion rate of advantageously 48 kHz, along with the necessary power amplification.

The data item to be converted - in the embodiment example with a width of 16 bits - is split, by a bit-splitter 6, into a high byte (8 bit) and a low byte (8 bit). This takes place in that the data item (DI) is divided by 256 (which corresponds to the possible valences of a byte). The whole-number result is the high byte; the remainder is given by the low byte. In a mathematical representation, it is possible to write the following: high byte = data item div 256, low byte = data item mod 256 or data item = high byte × 256 + low byte.

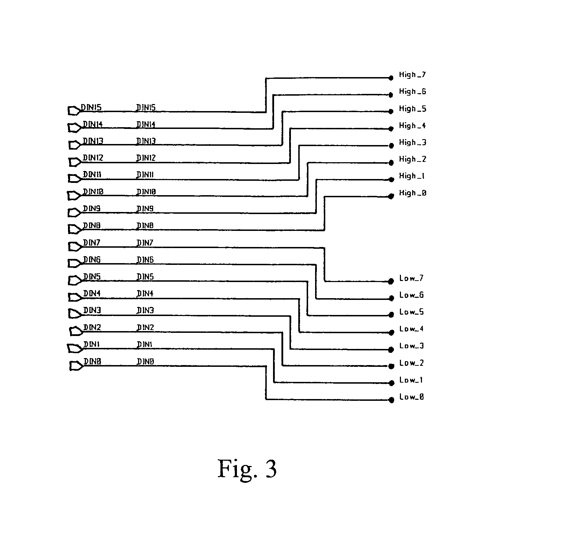

For the case in which the input data - that is, the data item (16 bit) to be converted - are already available in a desired, parallel form, as is given, for example, with a DSP/microcontroller implementation by storage, for example, in a 16-bit register or in 2 8-bit RAM storage sites, or with an FPGA implementation, the splitting into a low byte and a high byte takes place simply by the corresponding connection or branching of the parallel data bits into "low" or "high". A practical embodiment of the division or of the bit-splitter for the case of a 16-bit data item is shown in Fig. 3. In the implementation in a DSP or microcontroller, this can also take place with a suitable combination of mask, shift, and move operations.

If the data are present in a serial format, then the bit-splitter also comprises a serial/parallel (S/P) converter, which produces a parallel data flow, which in turn is split in accordance with Fig. 3. The S/P converter can be designed differently, depending on the serial protocol. The implementation of such S/P converters is not a problem for the specialist familiar with the state of the art.

Before the high byte arrives at the data input of the PWM modulator 7, the high byte is increased by a "1" if the low byte is not equal to 0 and remains the same if the low byte is equal to 0. The examination of this condition takes place by means of an 8-bit comparator 3, which generates an output signal according to low byte > or =0, which is next to the input of an adder. The high byte is increased in the adder 4 by a "1" if the output signal of the comparator 3 is a "1"; otherwise, it is slid through unchanged and arrives at the data input of the PWM modulator 7. The adder, the complement stage, and the comparator can be implemented either with standard logic gates (74HC283, 74HC85, 74HC04), or a programmable logic (PLD or FPGA). The PWM modulator 7 comprises an 8-bit counter and an 8-bit comparator and converts the high byte directly into the PWM signal. This PWM signal is amplified with an amplifier 9, according to the power, and is conducted to the plus terminal of the loudspeaker 18 via a capacitor 11 and an inductance 15. As buffers or amplifiers, it is possible to implement, for example, CMOS buffers, analog multiplexers, conduction drivers, impedance converters, rail-to-rail operation amplifiers, or a MOSFET single-ended, push-pull output stage with inverter, such as represented in Fig. 2, as a combination of an N channel and a P channel MOSFET.

The buffer stage must be non-inverting and its output impedance should be smaller, by a factor of 10-1000, than the impedance of the loudspeaker capsules. The loudspeaker terminal in which the diaphragm is moved outwards during the inflow of a current is designated as the plus terminal. This is important for the phase position of the sound, in particular with two or more channels. Dynamic loudspeakers (air-cored coil is moved in the magnetic field), piezoelectric sound converters, and capacitor converters are suitable as loudspeakers.

The second complement is formed from the low byte in a second complement stage 5. The negation of the low byte is needed in that, subsequently, the analog signal coming from this is at the negative pole of the loudspeaker. The output signal of the second complement stage is at the data input of the PWM modulator 8, which also comprises an 8-bit counter and an 8-bit comparator. The signal generated from the PWM modulator 8 is amplified with the amplifier 10 and the voltage is dampened by the factor 256 with a voltage divider, composed of the resistances 12, 13. The resulting PWM signal with the 1/256-fold amplitude is conducted to the minus terminal of the loudspeaker 18 via an LC filter 16, 17.

The addition of a digital "1" to the high byte, if the low byte is not equal to 0, is needed in order to take into consideration the overload during the formation of the second complement with the numerical value 0. With the second complement method, which is the most widespread form of representation, a positive number becomes a negative number in that it is first inverted bitwise, then a 1 is added to the formed number. This depiction functions in two directions - that is, it is also possible, without any problems, calculating from a negative number, to again obtain the corresponding positive number. The advantage of this method is that it gives only one representation for the 0 value. The addition of a "1" to the high byte represents a compensation, in order to obtain the signal corresponding actually to the data item (DI) at the loudspeaker 18, which is illustrated below.

The voltage ((DI div 256) + 1) × Ub/256 is at the plus terminal of the loudspeaker capsule 18, if the low byte - that is, (DI mod 256) - is > 0, and (DI div 256) × Ub/256, respectively, if the low byte - that is, (DI mod 256) - = 0. Ub is the supply voltage of the buffers 9 and 10 acting as amplifiers. The voltage (256 - (DI mod 256) mod 256) × Ub/(256 × 256) is at the minus terminal of the loudspeaker capsule 18.

The difference between the two voltages, which are thus at the loudspeaker, corresponds to DI × Ub/(256 × 256) and is the desired 16-bit conversion. As a result of the fact that the low-order bits are negated by the second complement formation, a differential voltage, which corresponds to the converted data value, is formed between the loudspeaker terminals.

The data, high byte or low byte, are taken over into the PWM modulators 7, 8 with the sample cycle fs. The internal 8-bit counter of the PWM stage is fed with the cycle f_PWM, which is 256 × n × fs. The factor n is a whole-number, for example, 4, and determines the ratio of the frequency of the PWM stage to the sample cycle. By using a counter cycle, which is 256 × n × fs, one guarantees that a surge is not produced with the counter cycle due to the periodic updating of the PWM value with the sample cycle fs. The higher the counter cycle, the better will be the dampening of the basic PWM frequency by a subsequently placed LC filter. An LC low-pass filter before the loudspeaker input is preferably dimensioned so that with the upper audio limit frequency of approximately 20 kHz, a dampening of the audio signal by 3dB is produced.

The output signal PWM_H of the PWM modulator 7 travels, after the power amplification in the amplifier 9, via the capacitor 11 and the inductance, to the plus terminal of the loudspeaker capsule 14. The inductance 15, for example, a coil, acts as a low-pass filter, and with the capacitor 11, undesired direct voltage fractions are filtered out. The output signal PWM_L of the PWM modulator 8 travels, after the power amplification in the amplifier 10, to the voltage divider 12, 13, which dampens the signal by a factor of 256. This factor corresponds to the value 2 raised to the power (item width of the high-order bit group), for example, 2⁸, 2⁶, etc... For example, the resistance 12 is 2.55 kΩ and the resistance 13 is 10 Ω. This PWM signal of a small amplitude arrives at the minus terminal of the loudspeaker 18 via the inductance 16.

The resistance values of 12 and 13, indicated as an example, assume, for better understanding, that the load due to the filter or loudspeaker impedance is negligibly small. In actual practice, the ratio of the resistances 12, 13 is selected in such a way that in the loaded state, a level of the PWM signal that is, as precisely as possible, smaller by a factor of 256, is produced, which comes from the low byte, in comparison to the signal that comes from the high byte.

The inductances 15 and 16 form - together with the capacitor 17, connected between the plus and minus terminals of the loudspeaker 14 - a low-pass filter, wherein an analog signal is produced from the amplified, pulse-width-modulated signal, and the frequency of the PWM stage, contained in the audio signal, is greatly dampened.

The invention is not limited by the described embodiment example, depicted in Fig. 1. The idea that is the basis of the invention is found in splitting a data item, which represents a digital audio signal, into two bit groups, and inverting one of them digitally. After the conversion into analog signals by a D/A converter 1,2, the two analog signals, corresponding to the bit groups, are conducted, separately from one another, to the plus and minus terminals of the loudspeaker 18. As is clarified in Fig. 1 by the boxes bordered by broken lines, any type of D/A conversion 1, 2 is in principle, conceivable ― optionally with an integrated or subsequent analog amplifier stage. Since such a D/A system with an analog amplifier requires a relatively high expenditure, causes signal distortions, and has a low efficiency, the preferred embodiment consists of an final stage, which is designed in the form of a digital amplifier. This amplifier concept is also known as a class-D amplification. A digital signal is thereby converted, by means of special digital modulators, into a bit stream, whose average value corresponds to the converted data. The binary amplitude information is therefore coded in the average value of a pulse signal. For this method, for example, the pulse-width modulation (PWM) or the sigma-delta modulation (SDM) are suitable. The signal formed thereby and modulated with respect to the pulse density can be converted by a simple low-pass filtering into the corresponding analog signal. In order to raise the digital audio signal to a suitable level to drive low-ohm loads, for example, of a loudspeaker, a pulse amplifier is used. Subsequently, the amplified signal is conducted to a low-pass filter, which produces an analog signal from the amplified modulated signal. The basic principle of such a D/A system, in which a PWM with a downstream pulse amplifier is used, is described in the DE 39 34 215. As already mentioned above, CMOS buffers, conduction drivers, analog multiplexers, impedance converters, rail-to-rail operation amplifiers, or a MOSFET single-ended, push-pull output stage with inverters can be used as amplifiers according to Fig. 2. The use of a switched final stage, or class-D final stage, has the advantage of a substantially higher efficiency in comparison to a traditional final stage. A digital amplifier working on this principle, with a delta-sigma modulator, is described in DE 196 19 208 A1. The contents of this document are incorporated herein by reference.

The elegant and simple implementation of a loudspeaker control, in accordance with the invention, is particularly advantageous. Thus, either direct on-chip PWM stages of modem DSP's (digital signal processors), RISC (reduced instruction set computer) microcontrollers, hardware implementations in FPGA's (field programmable gate arrays), or ASIC's (application specified integrated circuits) can be used as PWM modulators. Accordingly, the calculation of the data, which are loaded with the sample cycle fs into the PWM modulators, can take place in hardware (ASIC, FPGA) or software (DSP, microcontrollers). With apparatuses in which the audio input signal also has a digital format, the IC number and component cost can be reduced by the use of the invention.

Of course, the invention is not limited to the embodiment example described above. For example, data items with an arbitrary resolution (8, 16, 24, 32-bit, etc.) can be split into corresponding bit-splitters and can be converted into a pulse-width-modulated signal with digital modulators of a corresponding resolution. Also, the splitting of the data item, cited in the embodiment example, into a bit group with half a word width is not decisive for the functioning of the loudspeaker control, in accordance with the invention. The bit groups formed by the splitting of the data item can also have different lengths. Arbitrary data lengths are possible; the splitting could definitely take place into two unequally wide bit groups. For example, it would be conceivable to split an 18-bit sequence into a high-order bit sequence, 11-bit wide, and a low-order bit sequence, 7-bit wide. Of course, instead of the low-order bit group, the high-order bit group can also be negated. In actual practice, it is, of course, advantageous to select the width of the high-order bit sequence to be as wide as possible, in accordance with the limits of the technology used - essentially the cycle of the digital modulator ― in order to reduce the influence of the tolerances of the weighting element, that is, the dampening of the low-order bit sequence, but in the case under consideration, to reduce the influence of the resistance tolerances of the voltage divider. A not exactly suitable dampening produces distortions and harmonics. The weighting of the two signals, with respect to one another, can also take place by using amplifiers of different strengths 9, 10, which produce the desired ratio at the loudspeaker capsule 18. Instead of PWM modulators, all digital modulators or converters are, in principle, suitable, in which the average value of the resulting bit stream corresponds to the data to be converted.

Also, the way in which the high-order and low-order bit groups are prepared can be different from the example described above. In a simple implementation form of the circuit, in accordance with the invention, only the formation of the first complement can take place instead of the formation of the second complement - that is, the inverting of the individual bits of the low-order bit group, without the simultaneous increment of the high-order bit group.

## Claims

1. Circuit for the control of a loudspeaker with a loudspeaker capsule (18), wherein the circuit comprises a bit-splitter (6) for the division of a data item, representing an acoustic signal, into a high-order bit group and a low-order bit group, as well as two D/A converters (1, 2) for the D/A conversion of the high-order bit group and the low-order bit group, wherein the digital inputs of the D/A converters (1, 2) are connected each with an output of the bit-splitter (6), **characterized in that** a complement stage (5) for the negation of its bit group is connected in series with the D/A converter (2, 1), with the output of the one D/A converter (1, 2) being connected with a terminal of the loudspeaker capsule (18) and the output of the other D/A converter (2, 1) being connected with the other terminal of the loudspeaker capsule (18).

2. Circuit according to Claim 1, **characterized in that** at least one of the two D/A converters (1, 2) comprises an element for the weighting of the output signal, wherein the signal corresponding to the low-order bit group is weighted by a factor of 1/(2 raised to the power (word width of the high-order bit group)), relative to the signal corresponding to the high-order bit group, for example, a voltage divider, composed of resistances (12, 13) or an amplifier.

3. Circuit according to one of Claims 1 and 2, **characterized in that** the D/A converter (1, 2) comprises a digital modulator (7, 8), preferably a PWM modulator, or a sigma-delta modulator, with a downstream amplifier stage (9, 10), and a low-pass filter, downstream from the amplifier stage (9, 10), preferably in the form of coils (15, 16).

4. Circuit according to one of Claims 2 and 3, **characterized in that** the amplifier stage (9, 10) is a switched final stage, which is preferably designed as a MOSFET push-pull output stage with inverter.

5. Loudspeaker according to one of Claims 1 to 4, **characterized in that** a capacitor (17) is provided between the two terminals of the loudspeaker capsule (18) as a part of the low-pass filter.

6. Loudspeaker according to one of Claims 1 to 5, **characterized in that** an adder (4) for the addition of a digital value of 1 is connected in series with the data input of the D/A converter (1, 2) for the high-order bit group, with its control input being connected with the output of a comparator (3) and with the input of the comparator (3) being connected with the input of the complement stage (5).

7. Loudspeaker according to one of Claims 2 to 6, **characterized in that** as PWM modulators, on-chip PWM stages of modem DSP's, RISC microcontrollers, or hardware implementations in FPGA's or ASIC's are used.

8. Method for the control of a loudspeaker comprising a loudspeaker capsule (18) with an audio signal composed of digital data items, wherein the individual data item is divided into a high-order bit group and a low-order bit group, from which an analog signal is formed, **characterized in that** one of the two bit groups is negated before it is converted into an analog signal, with the analog signal coming from the negated bit group being laid at one terminal of the loudspeaker capsule (18) and the analog signal coming from the other bit group being laid at the other terminal of the loudspeaker capsule (18).

9. Method according to Claim 8, **characterized in that** the signal coming from the low-order bit group is weighted with the factor of 1/(2 raised to the power (word width of the high-order bit group)), relative to the signal coming from the high-order bit group, for example, via a voltage divider, formed from resistances (12, 13), or an amplifier.

10. Method according to one of Claims 8 and 9, **characterized in that** the D/A conversion takes place **in that** the individual bit group is converted by digital modulation, preferably PWM modulation or sigma-delta modulation, into a bit stream whose average value corresponds to the binary amplitude information of the bit group, and that the bit stream is amplified in an amplifier stage (9, 10) and is converted into an analog signal by means of low-pass filtering.

11. Method according to one of Claims 8 to 10, **characterized in that** the negating of the bit group takes place by the formation of the first complement.

12. Method according to one of Claims 8 to 10, **characterized in that** the negation of the bit group takes place by the formation of the second complement.

13. Method according to one of Claims 8 to 12, **characterized in that** the low-order bit group is negated.

14. Method according to one of Claims 8 to 13, **characterized in that** the high-order bit group is increased by a digital value of 1, if the low-order bit group is greater or smaller than 0.

15. Method according to one of Claims 8 to 14, **characterized in that** the data item is split into bit groups having a half-data-item width.
